Europäisches Patentamt

European Patent Office

Office européen des brevets

(19)

(11) **EP 1 263 132 B1**

(12) **EUROPEAN PATENT SPECIFICATION**

(45) Date of publication and mention
of the grant of the patent:
**10.08.2005 Bulletin 2005/32**

(51) Int Cl.[7]: **H03G 7/00**

(21) Application number: **02011764.4**

(22) Date of filing: **27.05.2002**

(54) **Variable signal attenuating circuit**

Variable Signaldämpfungsvorrichtung

Dispositif atténuateur variable de signaux

(84) Designated Contracting States:
**DE FR GB**

(30) Priority: **28.05.2001 JP 2001159424**

(43) Date of publication of application:
**04.12.2002 Bulletin 2002/49**

(73) Proprietor: **Pioneer Corporation
Meguro-ku, Tokyo (JP)**

(72) Inventor: **Honda, Jun
Tokorozawa-City, Saitama (JP)**

(74) Representative: **Goddar, Heinz J., Dr.
FORRESTER & BOEHMERT
Pettenkoferstrasse 20-22
80336 München (DE)**

(56) References cited:
**WO-A-99/22366          US-A- 5 883 963**

- **PATENT ABSTRACTS OF JAPAN vol. 017, no.
  676 (E-1475), 13 December 1993 (1993-12-13) -&
  JP 05 226953 A (SONY CORP), 3 September 1993
  (1993-09-03)**
- **E.F. STIKVOORT: "Digital dynamic range
  compressor for audio" JOURNAL OF THE
  AUDIO ENGINEERING SOCIETY., vol. 34, no. 1/2,
  1 - 1 January 1986, pages 3-9, XP002268580
  AUDIO ENGINEERING SOCIETY. NEW YORK.,
  US ISSN: 0004-7554**

**Description**

BACKGROUND OF THE INVENTION

1. Field of the Invention

The present invention relates to a variable signal attenuating circuit for use in an audio device such as a stereo, a television or the like.

2. Description of the Related Art

In an audio device such as a stereo, a television or the like, a variable signal attenuating circuit is typically used for adding an attenuation to an audio signal to be treated.

When an attenuation value set in the variable signal attenuating circuit is extremely large, an audio signal having passed through the variable signal attenuating circuit is excessively reduced in level, thereby causing inconveniences. In the case of a digital audio signal, no signal appears at the output of the variable signal attenuating circuit. Otherwise, the reproduced sound is so distorted. When, on the other hand, an analog audio signal is concerned, a reproduced signal is masked by noises, causing troubles such as difficulties experienced by a listener in listening to the reproduced signal.

Particularly, the number of bit of digital signals is finite in a digital variable signal attenuating circuit for use in a digital audio system, so that a bit utilization rate is lower as the attenuating circuit applies a larger amount of attenuation, thereby making the foregoing harmful influences more prominent.

US 5 883 963 discloses a similar variable signal attenuating circuit that contains a dynamic range compression part, but however, the compressed range does not depend on the attenuation value of the attenuating circuit. This causes dropouts of the signal due to the lower amplitude componants of the signal being attenuated below a noise threshold.

OBJECT AND SUMMARY OF THE INVENTION

The present invention has been conceived so as to eliminate the disadvantages mentioned above, and it is an object of the invention to provide a variable signal attenuating circuit which is capable of adjusting an output signal level in accordance with a set attenuation value.

The present invention provides a variable signal attenuating circuit for use in an audio device. The variable signal attenuating circuit includes attenuation value setting part for setting a predetermined attenuation value, dynamic range compression processor for compressing a dynamic range of an input signal within a predetermined range, and signal attenuator for attenuating the input signal which has passed through the dynamic range compression processor based on the attenuation value, wherein the dynamic range compression processor determines a compressed range based on the attenuation value when compressing the dynamic range of the input signal within the predetermined range.

BRIEF DESCRIPTION OF THE DRAWINGS

Fig. 1 is a block diagram illustrating a configuration of the present invention;
Fig. 2 is a block diagram illustrating a first embodiment of the present invention;
Fig. 3 is a diagram showing a signal conversion table in the embodiment illustrated in Fig. 2;
Fig. 4 is a graph showing a level conversion for input/output signals in the embodiment illustrated in Fig. 2;
Figs. 5A and 5B are explanatory diagrams for an effect produced by compressing the dynamic range of a signal;
Fig. 6 is a block diagram illustrating a second embodiment of the present invention; and
Fig. 7 is a table showing the relationship between an attenuation value and a dynamic range in the embodiment illustrated in Fig. 6.

DETAILED DESCRIPTION OF THE EMBODIMENTS

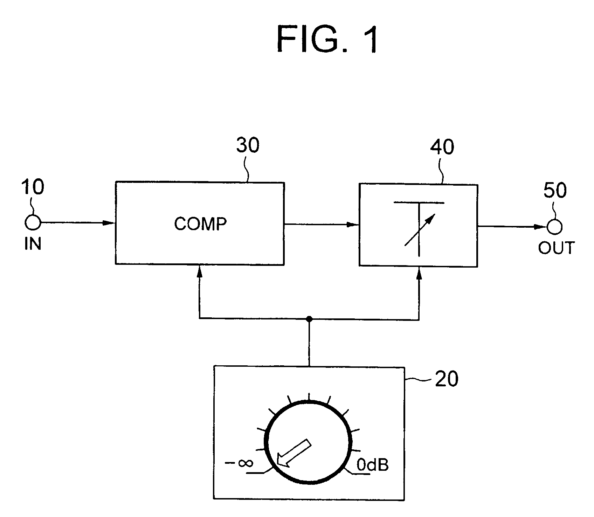

Fig. 1 is a block diagram illustrating a configuration of a variable signal attenuating circuit according to the present invention.

In Fig. 1, an input terminal 10 is provided for introducing an input signal into the circuit. The input signal may be an ordinary analog signal which is an electric signal simply converted from an audio signal such as music, voice and the like, or a digital signal produced by applying the analog signal with treatments of sampling, quantization or the like.

An attenuation value input part 20 is provided which is handled by a user of an audio device equipped with this attenuation circuit so as to input a desired signal attenuation value for adjusting the volume of an audio output signal as required. While Fig. 1 illustrates a so-called volume for conceptually representing such an attenuation setting operational procedure, the attenuation value may be set, for example, using input means such as a keyboard, a particular function key, or the like.

A dynamic range compression processing part (hereinafter simply called the "compression processing part") 30 is provided for compressing the dynamic range of an input signal supplied from the input terminal 10 in accordance with an attenuation value supplied through the attenuation value input part 20.

A signal attenuator 40 is provided for attenuating a signal, which has passed the compression processing part 30, in accordance with the attenuation value supplied via the attenuation input part 20 without affecting input and output impedances.

An output terminal 50 is provided which relays an attenuated signal, which has passed the signal attenuator 40, to another audio equipment which is the next stage of the attenuating circuit.

Next, the configuration illustrated in the block diagram of Fig. 1 will be described below in detail.

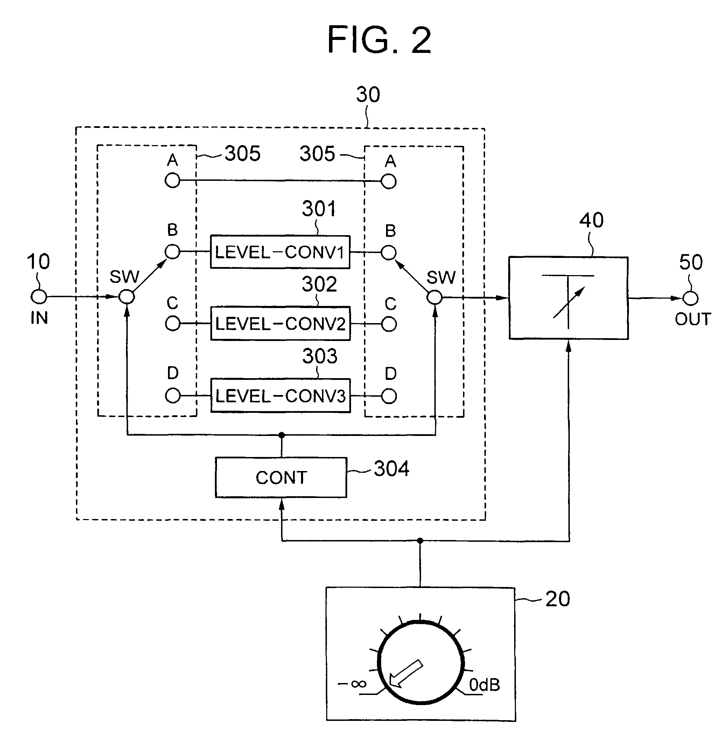

In Fig. 2, the compression processing part 30 comprises signal level conversion tables (hereinafter simply called the "conversion tables") 301 - 303; a control circuit 304; and a signal level conversion table switching circuit (hereinafter simply called the "switching circuit") 305. These circuits 301 - 305 may be based on a microcomputer which comprises a CPU, and memory elements such as a ROM (Read Only Memory), a RAM (Random Access Memory), and the like.

The conversion tables 301 - 303 may be implemented by a storage device, for example, a ROM or the like. Namely the conversion table is adapted to produce a certain output value in response to a certain input value.

The switching circuit 305 is adapted to select one of the conversion tables for use in response to a control instruction from the control circuit 304 and supplying an input signal to the selected table.

The operation of the embodiment illustrated in Fig. 2 will be described below.

First, the control circuit 304 reads an attenuation value β dB set in the attenuation value input part 20 to select a conversion table corresponding to the attenuation value. For the correspondence of the attenuation value to a conversion table, relationships, for example, shown below, may be previously assigned:

When β = 0 dB ; No Conversion Table
When β < 30 dB; Conversion Table 301
When β < 60 dB; Conversion Table 302
When β < 90 dB; Conversion Table 303

As appreciated, the division of the attenuation value β into how many sections, or the number of conversion tables is not limited to this embodiment, and the number of used conversion tables may be increased to divide the attenuation value β into a larger number of sections.

As the control circuit 304 selects a conversion table corresponding to the attenuation value β from the conversion tables 301 - 303, the control circuit 304 supplies the switching circuit 305 with a switching instruction for selecting the conversion table. As a result of this processing, the input signal via the input terminal 10 is supplied to the selected conversion table.

Now, description will be made on the conversion processing for an input signal level using the conversion tables. Assume in the following description that the input level is represented by a digital value which is quantized in a predetermined format.

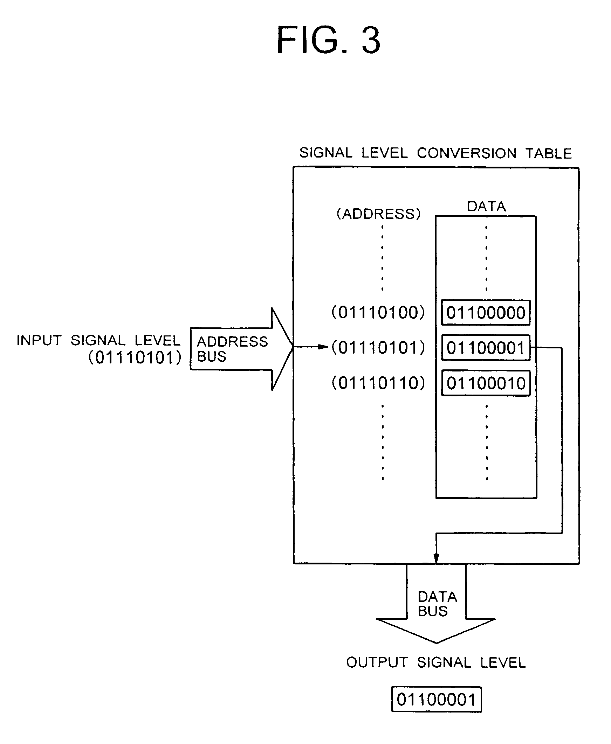

As described above, each of the conversion tables in this embodiment may be any circuit which outputs a predetermined constant output signal level in response to a predetermined input signal level in a one-to-one correspondence. This can be implemented, for example, by using a storage device such as a ROM, as shown in Fig. 3. Specifically, this can be implemented by adding the input signal level to an address bus of the storage device as an address signal, and extracting data stored at the address in the storage device from a data bus of the storage device as an output signal level.

When an input signal from the input terminal 10 is an analog signal, the foregoing processing should be performed after converting the input signal into a digital signal by an analog/digital converter (not shown).

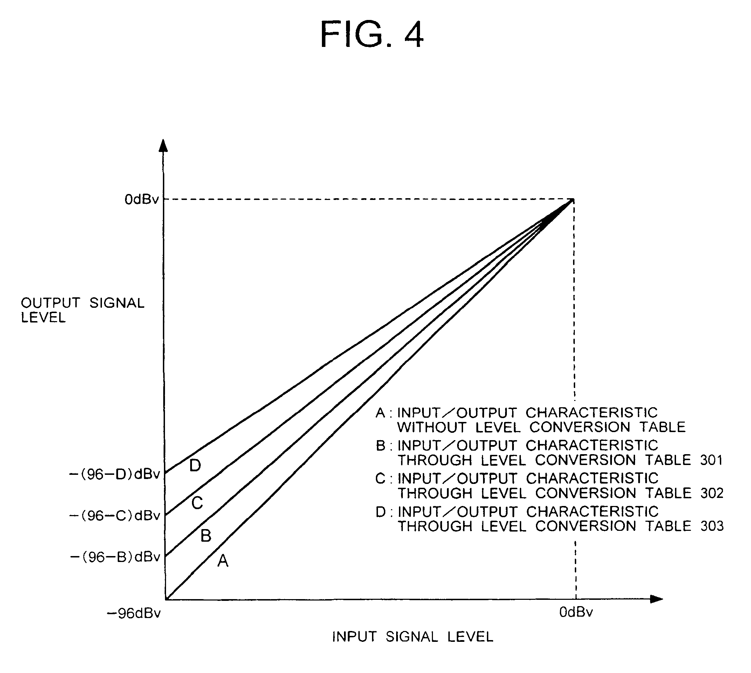

Next, the principles of the signal dynamic range compression through the signal level conversion processing will be described with reference to an input/output signal level conversion graph shown in Fig. 4.

While the signal level conversion processing is digitally performed using, for example, a ROM table as described above, the following description will be made using an analog value as a signal level for facilitating the understanding of the signal dynamic range compression through the signal level conversion processing.

In Fig. 4, a signal level conversion line A indicates the correspondence of the input signal level to the output signal level when an input signal level is not converted, i.e., when the switch of the switching circuit 305 is at a position A in the embodiment of Fig. 2. In this case, an input signal from the input terminal 10 simply passes through the compression processing part 30, so that the input to the compression processing part 30 is equal in signal level to the output from the compression processing case 30. When, therefore, the input signal level is, for example, at -20 dBv, the output signal level is also at -20 dBv, without a change in the signal dynamic range between the input and output of the compression processing part 30. In other words, the dynamic range of the output signal from the compression processing part 30 remains at 96 dB which is equal to the dynamic range of the input signal, as shown in Fig. 4.

While the dynamic range of the input signal is assumed to extend over 96 dB from 0 dBv to -96 dBv of the absolute signal level, it should be understood that this embodiment is not limited to these values, and a variety of values may be taken under design conditions.

Next, a signal level conversion line B in Fig. 4 will be described. When the signal level conversion line B is applied, the signal level is converted using the conversion table 301. Specifically, the signal level conversion line B indicates the correspondence of the input signal level to the output signal level when the switch of the switching circuit 305 is at a position B. As is also apparent from Fig. 4, in this case, the output signal level of the compression processing part 30 is amplified by B dB at a minimum value (-96 dBv) of the input signal level.

Specifically, the output signal level is also at 0 dBv when the input signal level is at 0 dBv, whereas the output level is at (-96+B) dBv when the input signal level is at -96 dBv. When the input signal level is between 0 dBv and -96 dBv, an output signal level found determined from the signal level conversion line B appears at the output of the compression processing part 30. As a result, the dynamic range of the output signal is compressed by B dB as compared with that of the input signal.

In the following, with the signal level conversion line C, the signal level is converted using the conversion table 302 in a similar manner, and the dynamic range of the converted output signal level is compressed by C dB. Likewise, with the signal level conversion line D, the dynamic range of the converted output signal level is compressed by D dB by using the conversion table 303.

In this embodiment, the relationship of:

$$(-96+D) \text{ dBv} > (-96+C) \text{ dBv} > (-96+B) \text{ dBv}$$

is established as shown in Fig. 4. Therefore, the dynamic range of the signal is compressed more in the order of the conversion lines B, C, D, i.e., in the order of the used conversion tables 301, 302, 303.

In other words, as a larger attenuation value β is set in the attenuation value input part 20, a bias value is increased at the minimum value of the input signal level on the signal level conversion line, resulting in a more compressed dynamic range of the output signal.

The signal output from the compression processing part 30 is attenuated by the signal attenuator 40 based on the attenuation value set in the attenuation value input part 20, and then output to the succeeding audio equipment through the output terminal 50.

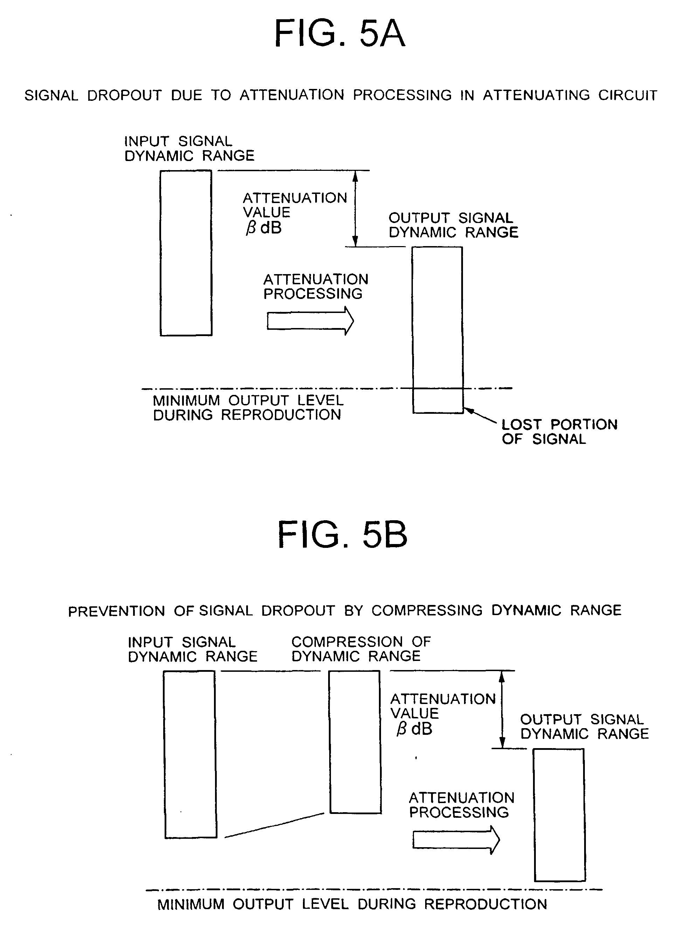

In a conventional variable attenuating circuit, when the user sets a large attenuation value, a lower part of the dynamic range of an attenuated signal may be below a minimum output level when the audio signal is reproduced, as shown in Fig. 5A, in which case the signal at a level below the minimum output level will be lost during reproduction.

On the other hand, in this embodiment, the dynamic range of an input signal is compressed in accordance with an attenuation value set by the user before the input signal is attenuated in the variable attenuating circuit. Therefore, as shown in Fig. 5B, a lower portion of the dynamic range after attenuation is less likely to be below a minimum output level during signal reproduction, thereby making it possible to prevent dropout of the signal.

When the user sets an even larger attenuation value, the dynamic range cannot be compressed by a thoughtlessly large amount for preventing unnaturalness in a reproduced audio signal, thereby possibly causing the dropout of signal during the reproduction. However, even in such a case, it is possible to largely prevent the dropout of signal as compared with an uncompressed dynamic range.

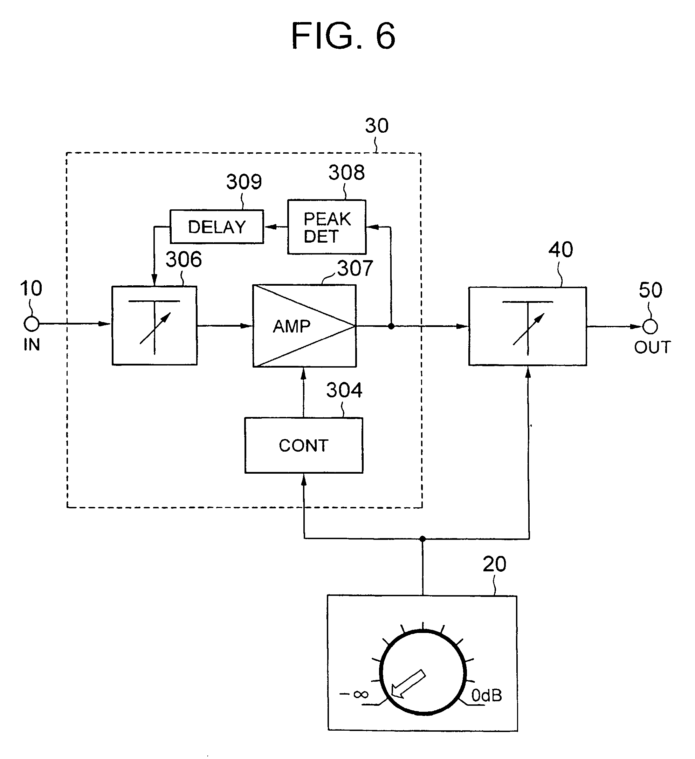

Next, Fig. 6 illustrates a second embodiment of the variable signal attenuating circuit in the block diagram of Fig. 1.

In Fig. 6, a compression processing part 30 comprises a control circuit 304; a variable attenuating circuit 306; a variable amplifying circuit 307; a peak detecting circuit 308; and a delay circuit 309.

The control circuit 304 is formed by a microcomputer for governing the overall operation of the compression processing part 30.

The variable attenuating circuit 306 and variable amplifying circuit 307 are connected in cascade, where the variable attenuating circuit 306 attenuates an input signal supplied via an input terminal 10, while the variable amplifying circuit 307 gives a gain to the input signal.

The peak detecting circuit 308 monitors an output level of the variable amplifying circuit 307, and supplies a control instruction to the variable attenuating circuit 306 when it detects a peak level which exceeds a predetermined threshold value. The delay circuit 309 gives a constant delay to a control instruction from the peak detecting circuit 308 to the variable attenuating circuit 306.

The operation of the embodiment illustrated in Fig. 6 will be described below.

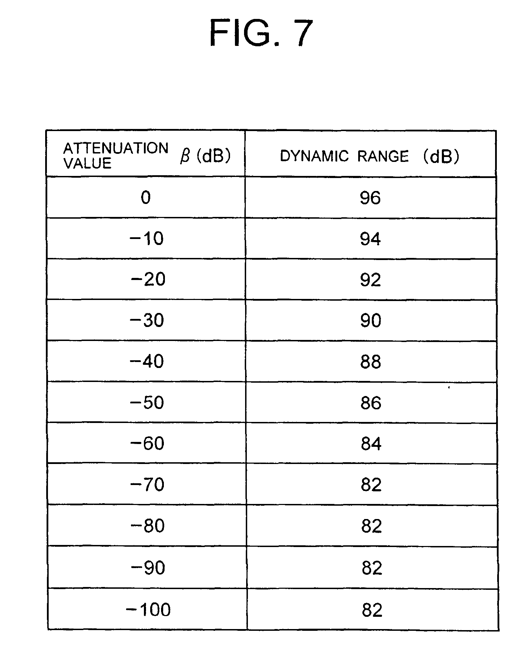

First, the control circuit 304 reads an attenuation value β set in the attenuation value input part 20 to select a dynamic range of a signal corresponding to the attenuation value. The relationship between the attenuation value β and the dynamic range may be previously specified, for example, in a table as shown in Fig. 7, such that the table is searched from the read value of β to find an associated dynamic range.

According to Fig. 7, the dynamic range is 84 dB when β=-60dB, thus producing a difference of 12 dB with respect to 96 dB which is assumed as the dynamic range of the input signal in this embodiment. Therefore, the control circuit 304 supplies a control instruction to the variable amplifying circuit 307 for amplifying the dynamic range by the difference to provide the dynamic range of 84 dB.

In this manner, the input signal level is uniformly increased by 12 dB, so that if the input signal level is originally high, the resulting signal level could exceed the upper limit value of 0 dBv of the dynamic range in this embodiment. To solve this problem, the peak detecting circuit 308 monitors the output level of the variable amplifying circuit 307 at all times to output a control instruction to the variable attenuating circuit 306 to promptly increase an attenuation value in this circuit when the output level exceeds the threshold value. In addition, for preventing auditory discomfort due to sudden fluctuations in the signal level caused by such feedback, a delay time is provided by the delay circuit 309 to the propagation of the control instruction.

As a result of the foregoing processing, the output signal level from the compression processing part 30 has its upper limit value restricted to 0 dBv, and its lower limit value set to -84 dBv which is the result of adding a bias of +12 dB to the lower limit value of the dynamic range of the input signal, i.e., -96 dBv. This is nothing but the compression, the dynamic range of 96 dB of the input signal is compressed by 12 dB.

In this embodiment, the input signal from the input terminal 10 is attenuated in the signal attenuator 40 by an attenuation value set in the attenuation value input part 20 after the input signal is compressed. It is therefore possible to provide the same result as that described in connection with Fig. 5 in the aforementioned embodiment.

Since, according to the present invention, the input signal is attenuated after its dynamic range is narrowed down in accordance with a set attenuation value, the signal will not disappear due to the attenuation even if the signal is at a low level.

Since, furthermore, the amount of compressed dynamic range is determined in accordance with a table which relates an attenuation value to the dynamic range in a predetermined manner, a change in sound quality is advantageously small even when the signal is at a high level.

Since, still further, the signal level is applied with a bias to compress the dynamic range, a further effect can be produced in that low level signals are easy to hear.

The features disclosed in the foregoing description, in the claims and/or the accompanying drawings may, both separately and in any combination thereof, be material for realising the invention in diverse forms thereof.

## Claims

1. A variable signal attenuating circuit (10, 20, 30, 40, 50) for use in audio equipment, comprising:

   attenuation value setting part (20) for setting a predetermined attenuation value;
   dynamic range compression processing part (30) for compressing a dynamic range of an input signal within a predetermined range; and
   signal attenuating part (40) for attenuating the input signal which has passed through said dynamic range compression processing part (30) based on said attenuation value,

   **characterised in that** said dynamic range compression processing part (30) determines a compressed range based on said attenuation value when compressing the dynamic range of the input signal within the predetermined range.

2. A variable signal attenuating circuit according (10, 20, 30, 40, 50) to claim 1, wherein said dynamic range compression processing part (30) includes:

   level converting part for converting the level of the input signal in accordance with a specified one of a plurality of level conversion functions different from one another; and
   specifying part for specifying one of said level conversion functions in accordance with the magnitude of an attenuation value set by said attenuation value setting part.

3. A variable signal attenuating circuit according (10, 20, 30, 40, 50) to claim 2, wherein each of said plurality of level conversion functions is represented by a plurality of conversion tables corresponding thereto.

4. A variable signal attenuating circuit (10, 20, 30, 40, 50) according to claim 2, wherein said level conversion functions are linear functions which specify the magnitude of the input signal as a parameter

5. A variable signal attenuating circuit (10, 20, 30, 40, 50) according to claim 2, wherein said level conversion functions have respective maximum function values equal to one another.

## Patentansprüche

1. Variabler Signaldämpfungsschaltkreis (10, 20, 30, 40, 50) zur Verwendung in einer Audioeinrichtung, mit folgenden Merkmalen:

   ein Dämpfungswert-Einstellteil (20) zum Einstellen eines vorgegebenen Dämpfungswertes;
   ein Dynamikbereich-Kompressions-Verarbeitungsteil (30) zum Komprimieren eines dynamischen Bereichs eines Eingangssignals innerhalb eines vorgegebenen Bereiches; und
   ein Signaldämpfungsteil (40) zum Dämpfen des Eingangssignals, das durch den Dynamikbereich-Kompressions-Verarbeitungsteil (30) gegangen ist, gestützt auf den Dämpfungswert,

   **dadurch gekennezeichnet, daß** der Dynamikbereich-Kompressions-Verarbeitungsteil (30) einen komprimierten Bereich gestützt auf den Dämpfungswert ermittelt; wenn er den Dynamikbereich des Eingangssignals innerhalb des vorgegebenen Bereichs komprimiert.

2. Variabler Signaldämpfungsschaltkreis (10, 20, 30, 40, 50) nach Anspruch 1, wobei der Dynamikbereich-Kompressions-Verarbeitungsteil (30) folgende Merkmale aufweist:

ein Pegelumwandlungsteil zum Umwandeln des Pegels des Eingangssignals abhängig von einer bestimmten Funktion unter mehreren Pegelumwandlungsfunktionen, die sich voneinander unterscheiden; und

ein Spezifikationsteil zum Spezifizieren einer der Pegelumwandlungsfunktionen abhängig von der Größe eines Dämpfungswertes, der von dem Dämpfungswert-Einstellteil eingestellt wird.

3. Variabler Signaldämpfungsschaltkreis (10, 20, 30, 40, 50) nach Anspruch 2, wobei jede der mehreren Pegelumwandlungsfunktionen durch mehrere entsprechende Umwandlungstabellen dargestellt wird.

4. Variabler Signaldämpfüngsschaltkreis (10, 20, 30, 40, 50) nach Anspruch 2, wobei die Pegelumwandlungsfunktionen lineare Funktionen sind, welche die Größe des Eingangssignals als einen Parameter spezifizieren.

5. Variabler Signaldämpfungsschaltkreis (10, 20, 30, 40, 50) nach Anspruch 2, wobei die Pegelumwandlungsfunktionen entsprechende maximale Funktionswerte haben, die einander gleich sind.

**Revendications**

1. Circuit d'atténuation de signal variable (10, 20, 30, 40, 50) destiné à être utilisé dans un équipement audio, comprenant :

une partie de réglage de valeur d'atténuation (20) pour régler une valeur d'atténuation prédéterminée ;

une partie de traitement de compression de plage dynamique (30) pour compresser une plage dynamique d'un signal d'entrée à l'intérieur d'une plage prédéterminée ; et

une partie d'atténuation de signal (40) pour atténuer le signal d'entrée qui a traversé ladite partie de traitement de compression de plage dynamique (30) en se basant sur ladite valeur d'atténuation,

**caractérisé en ce que** ladite partie de traitement de compression de plage dynamique (30) détermine une plage compressée en se basant sur ladite valeur d'atténuation lors de la compression de la plage dynamique du signal d'entrée à l'intérieur de la plage prédéterminée.

2. Circuit d'atténuation de signal variable (10, 20, 30, 40, 50) selon la revendication 1, dans lequel ladite partie de traitement de compression de plage dynamique (30) inclut :

une partie de conversion de niveau pour convertir le niveau du signal d'entrée selon une spécifiée parmi une pluralité de fonctions de conversion de niveau différentes les unes des autres ; et

une partie de spécification pour spécifier une parmi lesdites fonctions de conversion de niveau selon l'amplitude d'une valeur d'atténuation réglée par ladite partie de réglage de valeur d'atténuation.

3. , Circuit d'atténuation de signal variable (10, 20, 30, 40, 50) selon la revendication 2, dans lequel chacune parmi ladite pluralité de fonctions de conversion de niveau est représentée par une pluralité de tables de conversion correspondant à celle-ci.

4. Circuit d'atténuation de signal variable (10, 20, 30, 40, 50) selon la revendication 2, dans lequel lesdites fonctions de conversion de niveau sont des fonctions linéaires qui spécifient l'amplitude du signal d'entrée comme un paramètre.

5. Circuit d'atténuation de signal variable (10, 20, 30, 40; 50) selon la revendication 2, dans lequel lesdites fonctions de conversion de niveau ont des valeurs de fonction maximum respectives les unes aux autres.

# FIG. 1

EP 1 263 132 B1

# FIG. 2

# FIG. 3

SIGNAL LEVEL CONVERSION TABLE

(ADDRESS)    DATA

INPUT SIGNAL LEVEL (01110101)  ADDRESS BUS

(01110100)  01100000
(01110101)  01100001
(01110110)  01100010

DATA BUS

OUTPUT SIGNAL LEVEL

01100001

# FIG. 4

A : INPUT／OUTPUT CHARACTERISTIC
WITHOUT LEVEL CONVERSION TABLE
B : INPUT／OUTPUT CHARACTERISTIC
THROUGH LEVEL CONVERSION TABLE 301
C : INPUT／OUTPUT CHARACTERISTIC
THROUGH LEVEL CONVERSION TABLE 302
D : INPUT／OUTPUT CHARACTERISTIC
THROUGH LEVEL CONVERSION TABLE 303

OUTPUT SIGNAL LEVEL

0dBv

$-(96-D)$dBv

$-(96-C)$dBv

$-(96-B)$dBv

$-96$dBv

0dBv

INPUT SIGNAL LEVEL

# FIG. 5A

SIGNAL DROPOUT DUE TO ATTENUATION PROCESSING IN ATTENUATING CIRCUIT

INPUT SIGNAL
DYNAMIC RANGE

ATTENUATION
VALUE
$\beta$ dB

OUTPUT SIGNAL
DYNAMIC RANGE

ATTENUATION
PROCESSING

MINIMUM OUTPUT LEVEL
DURING REPRODUCTION

LOST PORTION
OF SIGNAL

# FIG. 5B

PREVENTION OF SIGNAL DROPOUT BY COMPRESSING DYNAMIC RANGE

INPUT SIGNAL
DYNAMIC RANGE

COMPRESSION OF
DYNAMIC RANGE

ATTENUATION
VALUE
$\beta$ dB

OUTPUT SIGNAL
DYNAMIC RANGE

ATTENUATION
PROCESSING

MINIMUM OUTPUT LEVEL DURING REPRODUCTION

11

# FIG. 6

# FIG. 7

| ATTENUATION VALUE $\beta$ (dB) | DYNAMIC RANGE (dB) |
|---|---|
| 0 | 96 |
| −10 | 94 |
| −20 | 92 |
| −30 | 90 |
| −40 | 88 |
| −50 | 86 |
| −60 | 84 |
| −70 | 82 |
| −80 | 82 |
| −90 | 82 |
| −100 | 82 |